# EUROPEAN PATENT SPECIFICATION

(11) **EP 0 500 965 B1**
(45) Date of publication and mention of the grant of the patent: **10.01.1996**
(21) Application number: 91915996.2
(22) Date of filing: 13.09.1991
(51) Int. Cl.: H01L 23/36

(54) **SEMICONDUCTOR DEVICE HAVING HEAT RADIATING FIN ASSEMBLY AND CASE FOR CONTAINING THE SAME**
HALBLEITERANORDNUNG MIT WÄRMESTRAHLENDER FLÜGELANORDNUNG UND GEHÄUSE FÜR DIESELBE
DISPOSITIF A SEMI-CONDUCTEUR AVEC ENSEMBLE D'AILETTES THERMORAYONNANTES ET BOITIER RECEPTEUR

(30) Priority: 13.09.1990 JP 245044/90
(43) Date of publication of application: 02.09.1992
(73) Proprietor: FUJITSU LIMITED, Kawasaki-shi, Kanagawa 211 (JP)
(72) Inventor: ANDO, Yukio, c/o Fujitsu Limited, Kawasaki-shi, Kanagawa 211 (JP)
(74) Representative: Gibbs, Christopher Stephen
(86) International application number: JP9101221
(87) International publication number: WO9205581

(56) References cited:
- JP-U- 1 158 494
- JP-U- 2 093 290
- JP-U-64 017 993
- JP-Y-59 043 276
- IBM TECHNICAL DISCLOSURE BULLETIN. vol. 14, no. 3, August 1971, NEW YORK US page 738 F.W. EDMONT 'Container for Chip Carrier Assemblies'
- Conrad Electronics Catalogue 1990, Conrad Electronics, Hirschau, Germany, page 493.

## Description

### TECHNICAL FIELD

The present invention relates to a semiconductor device with a heat radiating fin assembly and to a container for housing the same.

### BACKGROUND ART

In general, semiconductor devices include a block shaped package body in which an IC chip is sealed and a large number of leads which project out from the opposing sides of the package body and are electrically connected to the IC chip. Various types of packages for semiconductor devices are known. As typical examples, mention may be made of SOP (small outline packages), QFP (quad flat packages), and PGA (pin grid array packages).

In recent years, progress has been made in making semiconductor devices higher in density. Along with this, the amount of heat generated has increased and therefore it is becoming difficult to sufficiently cool the semiconductor devices with just radiation of heat from the package body itself. Therefore, heat radiating fin assemblies are being attached to the package bodies so as to enable efficient radiation of heat from the semiconductor devices. Usually, a heat radiating assembly is constructed of a support column which is designed to be affixed to the package body of a semiconductor device and a large number of fins which extend from the support column in the radial direction and are arranged at equal intervals along the axial direction of the support column. Such a device is known from JP-Y2-59-43276.

In a high density semiconductor device, the pitch of the arrangement of the large number of leads projecting out from the opposing sides of the package body is extremely small, therefore if even one of the leads deforms slightly, it becomes impossible to accurately mount the semiconductor device on the printed circuit board. Therefore, when transporting this type of semiconductor device, it is necessary to provide protection so that the leads of the semiconductor device does not come into contact with the human hand or other objects.

In the past, use has been made of a protective carrier for holding individual semiconductor devices so as to prevent damage to the leads of the semiconductor device during shipment. This protective carrier is comprised of a frame accommodating the package body of the semiconductor device, with a lock mechanism incorporated for preventing the package body from falling out of the frame accommodating it. Further, at the inside edge of the frame of the protective carrier, a large number of fine grooves are formed at the same pitch as the pitch of arrangement of the leads, so that the leads also become accommodated in the fine grooves at the same time as the package body is accommodated in the frame. During shipment, the semiconductor devices are placed in a tray or other container in the state carried by the protective carrier. Therefore, so long as the semiconductor device is held in the protective carrier, damage to the leads can be avoided.

However, a problem with the method of shipment of a semiconductor device discussed above is that the transport costs become too high, it has been pointed out. What this means is that the protective carrier has the complicated structure as mentioned above and therefore the protective carrier itself is relatively expensive. Further, the same number of protective carriers as the number of semiconductor devices to be shipped is required.

Another problem with the use of protective carriers is that when the semiconductor device is mounted on the printed circuit board, there is work involved in removing the semiconductor device from the protective carrier, it has been pointed out. When removing the semiconductor device from the protective carrier by manual labor, the leads are easily damaged when the semiconductor device is removed from the protective carrier, so considerable care must be taken when removing the semiconductor device. On the other hand, when trying to automatically supply semiconductor devices from a tray or other container to an automatic mounting machine for automatically mounting the semiconductor devices on a printed circuit board, an automatic extraction machine is required for automatically extracting the semiconductor devices from the protective carriers. Such an automatic extraction machine would be considerably expensive.

Japanese Unexamined Utility Model Publication (Kokai) No. 1-158949 discloses a transport carrier which is able to hold a number of semiconductor devices having heat radiating fin assemblies. In this transport carrier, use is made of the heat radiating fin assembly to hold the semiconductor device. As mentioned in detail, the transport carrier is comprised of a long box-shaped casing, which box-shaped casing is arranged so that its axial line in the longitudinal direction becomes horizontal. The front wall of the box-shaped casing is hinged with the top wall at its upper edges and can be freely opened or closed.

However, it is difficult to automatically remove semiconductor devices from the carriers with box-shaped casings as mentioned above and to supply them to an automatic semiconductor device mounting machine. That is, the support columns of the heat radiating fin assemblies are not constrained at all in the semicircularly cut away portion of the horizontal support plate member, so the plurality of semiconductor devices accommodated in the box-shaped casing cannot all be given the same orientation. While it might be possible to develop an automatic extraction machine which can automatically extract the plurality of the semiconductor devices oriented in different directions and give them a predetermined orientation, considerable cost would be required for developing such an automatic extraction machine. An assembly of an electronic device whose package has an orientation groove therein, and a box-shaped container holding the device, whereby the container has an extended guide element for engaging the groove, is known from JP-U-64-17993.

### DISCLOSURE OF THE INVENTION

Therefore, the main object of the present invention is to provide a semiconductor device provided with a rectangular package body, a large number of leads projecting out from the package body, and a heat radiating fin assembly provided at the top of the package body, in which semiconductor device use is made of the heat radiating fin assembly for accommodating and holding the package body in the container and the accommodation and holding of the package body are done in a manner so as to enable protection of the leads and to enable orientation of the package body to a predetermined direction.

According to the present invention, the heat radiating fin assembly includes a support column extending vertically from the top surface of the package body and at least one heat radiating fin extending in the radial direction from the support column, the heat radiating fins are supported by direct or indirect engagement with the container, and the support is achieved without the leads which project out from the package body contacting anything at all. Further, according to the present invention, consideration is given so that there can be no change in direction when the semiconductor device is accommodated once in the container in a predetermined direction.

### BRIEF DESCRIPTION OF THE DRAWINGS

The present invention will be explained in further detail referring to the attached drawings.

Figure 1 is a perspective view of a first embodiment of the semiconductor device according to the present invention.

Figure 2 is a perspective view of the plate-shaped member mounted to the topmost heat radiating fin of the heat radiating fin assembly of Fig. 1 and part of the box-shaped container accommodating and holding the semiconductor device of Fig. 1.

Figure 3 is an enlarged perspective view showing the plate-shaped member of Fig. 2 partially cut away.

Figure 4 is a perspective view the same as Fig. 1 and showing a modified embodiment of the semiconductor device of Fig. 1.

Figure 5 is a perspective view corresponding to Fig. 2.

Figure 6 is a perspective view corresponding to Fig. 3.

Figure 7 is a perspective view the same as Fig. 1 and showing another modified embodiment of the semiconductor device of Fig. 1.

Figure 8 is a perspective view of a part of the box-shaped container accommodating and holding the semiconductor device of Fig. 7.

Figure 9 is a perspective view of a second embodiment of the semiconductor device according to the present invention.

Figure 10 is a perspective view of the plate-shaped member mounted to the support column of the heat radiating fin assembly of Fig. 9 and part of the box-shaped container accommodating and holding the semiconductor device of Fig. 9.

Figure 11 is a perspective view showing a third embodiment of the semiconductor device according to the present invention.

Figure 12 is a plane view of a modification of the plate-shaped member of Fig. 11.

Figure 13 is a plane view of another modification of the plate-shaped member of Fig. 11.

Figure 14 is a plane view of a fourth embodiment of the semiconductor device according to the present invention.

Figure 15 is a top view of the box-shaped container for accommodating and holding the semiconductor device of Fig. 14.

Figure 16 is a sectional view along the line XVI-XVI of Fig. 17A showing a fifth embodiment of the semiconductor device according to the present invention.

Figure 17A is a plane view of the tray for accommodating and holding the semiconductor device according to the present invention.

Figure 17B is a top view seen along line B-B of Fig. 17A.

### BEST MODE FOR CARRYING OUT THE INVENTION

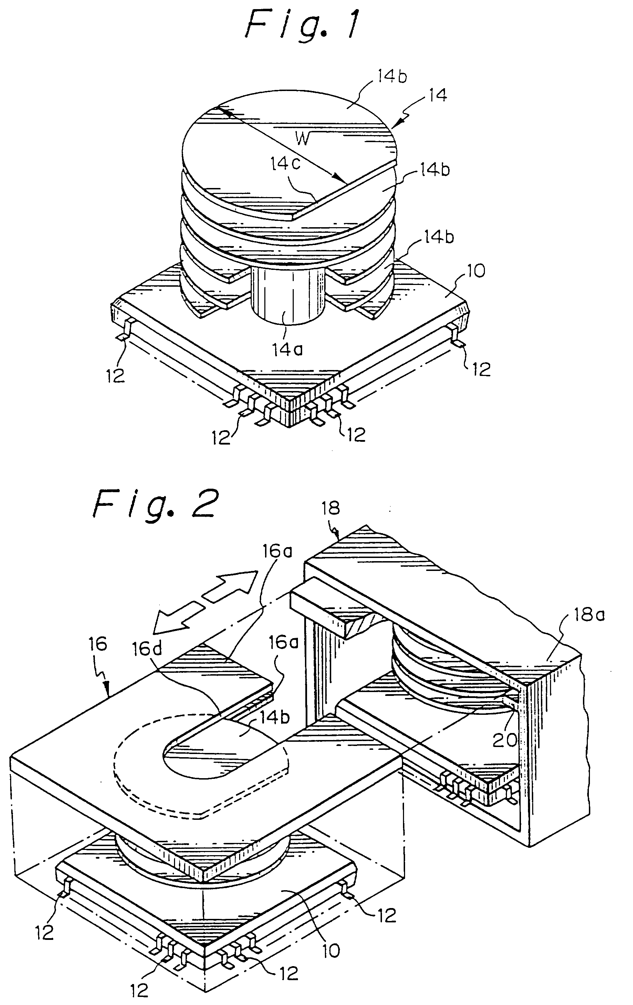

Referring to Fig. 1 and Fig. 2, a first embodiment of the semiconductor device according to the present invention is shown, which semiconductor device is of the type generally known as a QFP (quad flat package). The semiconductor device includes a rectangular package body 10 in which an IC chip is sealed, a large number of leads 12 projecting out from the four sides of the package body 10, and a heat radiating fin assembly 14 mounted to the top surface of the package body 10. The package body 10 is formed, for example, from a plastic material or a ceramic material. The lead array constituted by the large number of leads 12 projecting out from the four sides of the package body 10 form overall a rectangular contour.

The heat-radiating fin assembly 14 includes a support column 14a extending vertically from the top surface of the package body 10 and a plurality of heat-radiating fins 14b extending integrally from the support column 14a out to the radial direction and arranged at equal intervals along the axial direction of the support column 14a. The support column 14a and the heat-radiating fins 14b are formed from a metal material with good heat conductivity, for example, aluminum or copper. The support column 14a is, for example, soldered to a metal surface which lies partially exposed at the top surface of the package body 10. Note that in this embodiment, as clear from Fig. 1, the support column 14a is provided with a circular lateral sectional shape. The heat-radiating fins 14a are also circular.

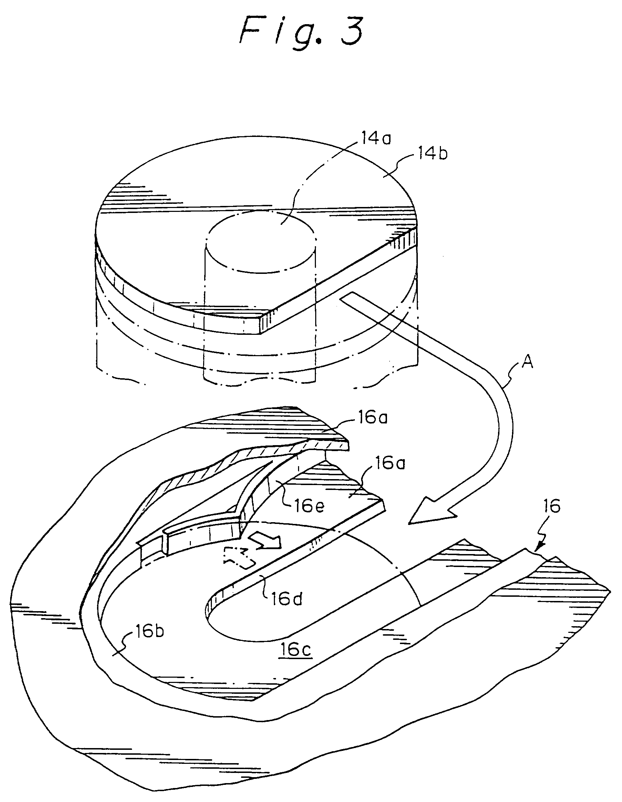

As shown in Fig. 1, part of the topmost heat radiating fin 14b is cut away. The cutaway surface 14c extends in parallel to the side of the package body 10. As clear from Fig. 2, the plate-shaped member 16 is made to be mounted at the topmost heat-radiating fin 14b. As best illustrated in Fig. 3, the plate-shaped member 16 is constituted by a pair of rectangular plate elements 16a and 16a arranged at a space from each other and a rectangular core element 16b arranged between the two. These elements are preferably formed from a hard plastic material and affixed together integrally.

A depression 16c is formed in the plate-shaped member 16, which depression 16c extends from the center of one side of the plate-shaped member 16 past the center of the same. The width of the depression 16c is made somewhat larger than the width W of the topmost heat radiating fin 14b (that is, the diameter of the heat-radiating fin 14b measured from the center location of the cutaway surface 14c). Further, as clear from Fig. 1 and Fig. 3, long cutaway portions 16d and 16d are formed in the pair of rectangular plate elements 16a and 16a, which cutaway portions are arranged at the center of the depression 16c and extend past the center of the plate-shaped member 16. The widths of the cutaway portions 16d and 16d are made somewhat larger than the diameter of the support column 14a of the heat-radiating fin assembly 14. By this construction, it is possible to accommodate the topmost heat-radiating fin 14b in the depression 16c as shown by the arrow A in Fig. 3.

Figure 2 shows the state with the topmost heat-radiating fin 14b completely accommodated in the depression 16c. At this time, the center of the topmost heat-radiating fin 14b substantially coincides with the center of the plate-shaped member 16. As shown in Fig. 3, at one of the side walls forming the depression 16c, a flat spring element 16e is integrally assembled. When the heat-radiating fin 14b is completely accommodated in the depression 16c, the flat spring element 16e snap-engages with the heat-radiating fin 14b. Therefore, after the topmost heat-radiating fin 14b is completely accommodated in the depression 16c, a suitable tensile force must be exerted on the heat radiating fin 14b to pull the heat-radiating fin 14b out from the depression 16c. The point to be noted here is that the cutaway portion 14c of the heat-radiating fin 14b is engaged with the other side wall formed by the depression 16c, so the heat-radiating fin 14b will not be able to rotate or displace in the depression 16c. In other words, once the heat-radiating fin 14b is accommodated in the depression 16c, the package body 10 is oriented to a predetermined direction at all times with respect to the plate-shaped member 16.

Referring to Fig. 2, the box-shaped container 18 for accommodating and holding the semiconductor device is partially shown. This box-shaped container 18 has a long shape and is opened at one end as shown in Fig.

2. Guide elements 20 are provided at the inside surfaces of the two walls of the box-shaped container 18 along the longitudinal axial direction of the same (note that only one is shown in Fig. 2). If a plate-shaped member 16 is accommodated between these guide elements 20 and the top wall portion 18a of the box-shape container 18, the semiconductor device as a whole is hung from the plate-shaped member 16 and the leads 12 will never come into contact with the inside surface of the bottom wall of the box-shaped container 18.

A plurality of semiconductor devices are held in the box-shaped container 18 in a mutually aligned state. The point to be noted here is that a rectangular contour is given to the plate-shaped member 16, with the dimensions of the contour shape being made larger than the dimensions of the contour shape of the lead array comprised of the large number of leads 12. Therefore, groups of leads, of two package bodies adjoining each other in the box-shaped container 18, projecting out facing each other will never come into contact. Note that in Fig. 2, the contour shape of the plate-shaped member 16 is shown by the broken line around the package body 10. Further, if a plate-shaped member 16 is accommodated between the guide elements 20 and the top wall 18a of the box-shaped container 18, the opposing side edges of the plate-shaped member 16 in the lateral direction will be engaged with the inside surfaces of the two side walls of the box-shaped container 16 and therefore the plate-shaped member 16 cannot rotate or change in position in the box-shaped container 18. That is, once the plate-shaped member 16 is accommodated in the box-shaped container 18, the orientation of the plate-shaped member 16 will remain unchanged. Therefore, all of the plurality of the semiconductor devices accommodated and held in the box-shaped container 18 can be given the same orientation.

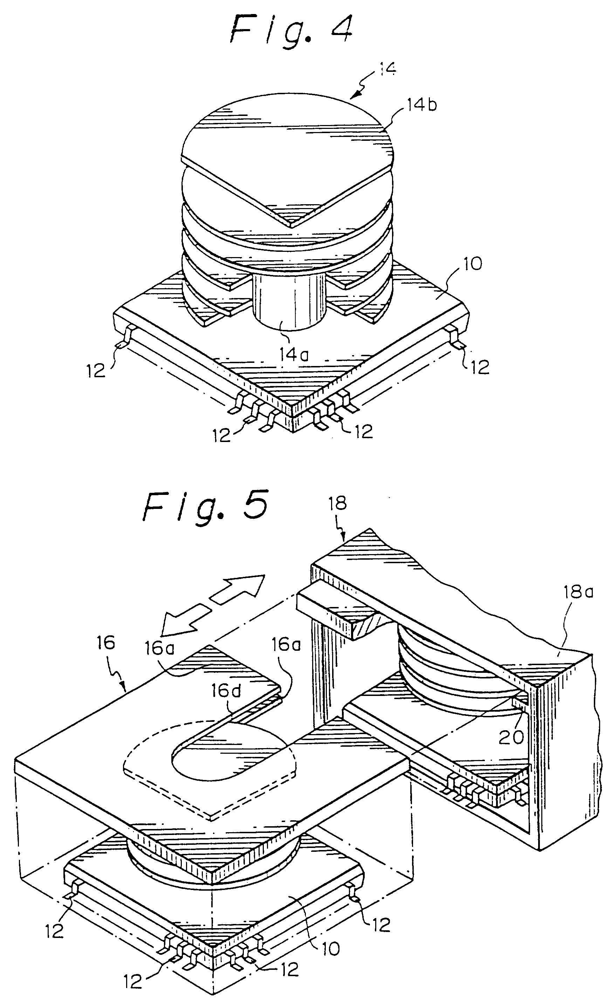

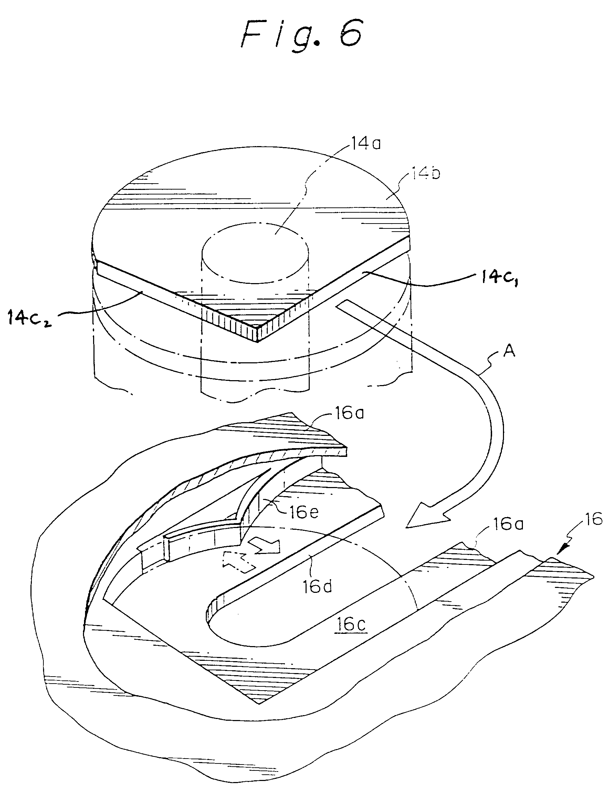

Referring to Fig. 4 to Fig. 6, a modified embodiment of the first embodiment according to the present invention will be shown. In this modified embodiment, two cutaway surfaces 14C₁ and 14C₂ are formed in the topmost heat radiating fin 14b, with these cutaway surfaces forming a right angle with each other. The bottom of the depression 16c formed in the plate-shaped member 16 is made a flat surface level with the cutaway surface 14C₂. When the topmost heat radiating fin 14b is completely accommodated in the depression 16c of the plate-shaped member 16, the rotation or change in position of the heat radiating fin 16b is constrained by the two cutaway surfaces 14C₁ and 14C₂, so the orientation of the semiconductor device with respect to the plate-shaped member 16 becomes much securer than in the above-mentioned embodiment.

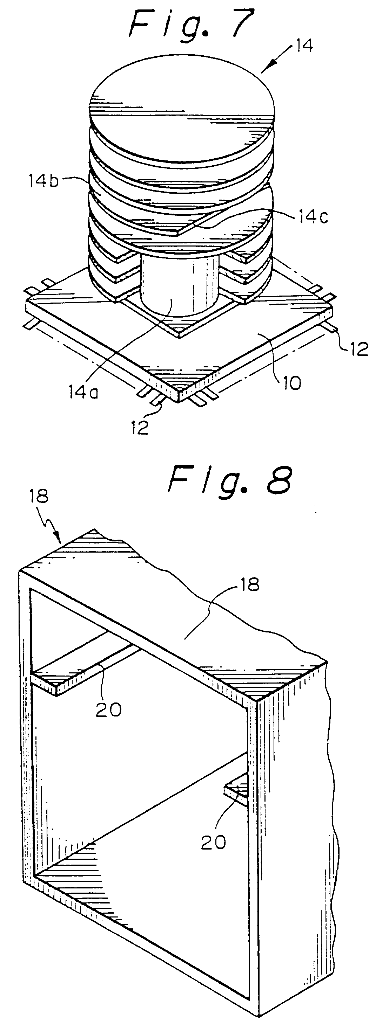

Referring to Fig. 7, another modified embodiment of the first embodiment according to the present invention will be shown. In this modified embodiment, a cutaway surface 14c is formed not at the topmost heat radiating fin, but at the intermediate heat radiating fin 14b. Such an intermediate heat radiating fin 14b may be provided with a plate-shaped member 16 as shown in Fig. 2 and Fig. 3 as well. In Fig. 8 is shown a box-shaped container 18 for accommodating and holding the semiconductor device of Fig. 7. In this box-shaped container 18, the distance between the guide elements 20 and the top wall 18a is made somewhat larger than the distance between the topmost heat radiating fin and the intermediate heat radiating fin 14b. This enables the semiconductor device of Fig. 7 to be accommodated and held in the box-shaped container 18.

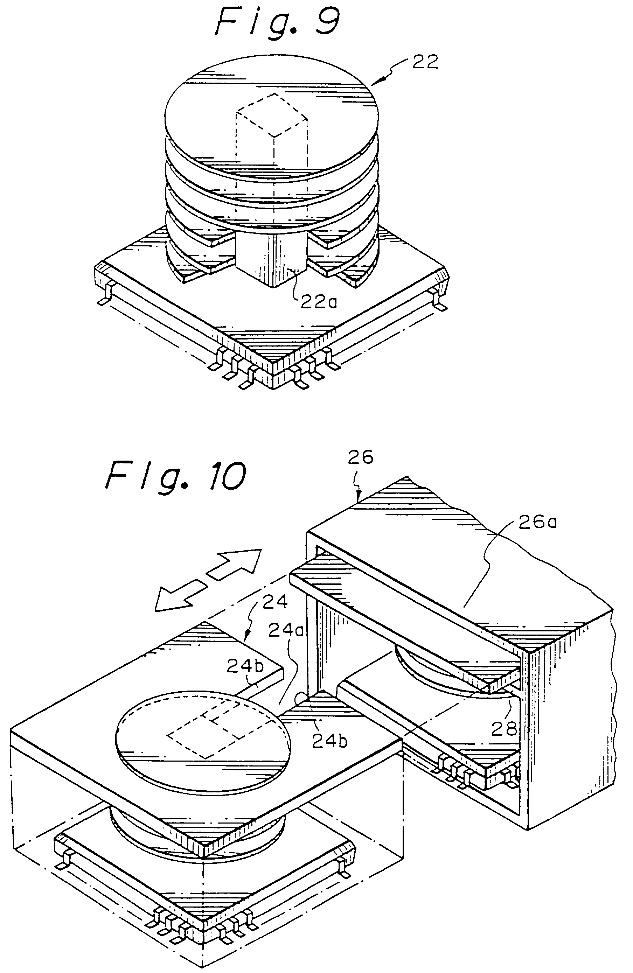

Referring to Fig. 9 and Fig. 10, a second embodiment of the semiconductor device according to the present invention will be shown. In this embodiment, the heat radiating fin assembly 22 is constituted in the same way as in the above-mentioned first embodiment, but the support column 22a is given a rectangular lateral cross-section different from the above-mentioned embodiment, as clear from Fig. 9. As shown in Fig. 10, the plate-shaped member 24 is comprised of a simple rectangular plate element 24a. The rectangular plate element is also preferably formed from a hard plastic material. The plate-shaped member 24 has the cutaway portion 24a formed in it, which cutaway portion 24a extends from the center location at one side of the plate-shaped member past the center. The width of the cutaway portion 24a is made somewhat larger than the width of the support column 22a of the heat radiating fin 22, therefore the support column 22a can be accommodated in the cutaway portion 24a. Thus, the plate-shaped member 24 can be mounted to the support column 22a between the topmost heat radiating fin and the heat radiating fin just under it as shown in Fig. 10. The point to be noted here is that the two side walls 24b forming the cutaway portion 24a can be engaged with the opposing surfaces of the support column 22a, so the support column 22a cannot rotate or change in position in the cutaway portion 24a. That is, by accommodating the support column in the cutaway portion 24a, the package body may be oriented in a predetermined direction at all times with respect to the plate-shaped member 24.

The box-shaped container 26 for accommodating and holding the semiconductor device of Fig. 9 may also be constructed similarly to the case of the first embodiment. The distance between the top wall 26a of the box-shaped container 26 and the guide elements 28 is made a magnitude enabling the plate-shaped member 24 to be accommodated. Further, in the same way as in the first embodiment, the dimensions of the contour shape of the plate-shaped member 24 are made larger than the dimensions of the contour shape of the lead array comprised of the larger number of leads. A suitable snap engagement means (not shown) is provided at one or both of the two side walls 24b of the cutaway portion 24a, by which it is possible to have the support column 22a constrained in the fully accommodated position when the support column 22a is completely accommodated in the cutaway portion 24a.

Therefore, even in the second embodiment shown in Fig. 9 and Fig. 10, the leads of the semiconductor devices can be protected from damage and all of the plurality of semiconductor devices accommodated and held in the box-shaped container 26 can be oriented in the same direction.

In the second embodiment, a rectangular lateral cross-section is given to the support column 22a as a whole, but it is also possible to give such a lateral sectional shape to just a part of it and to mount the plate-shaped member 24 there. Further, instead of the support column 22a with the rectangular cross-section, it is also possible to use a support column with a circular cross-section having a diameter larger than the width of the cutaway portion 24a. In this case, a pair of parallel grooves may be formed at the two sides of the circular section support column in the direction of its diameter and the two side walls 24b of the cutaway portion 24a may be engaged with the pair of parallel grooves.

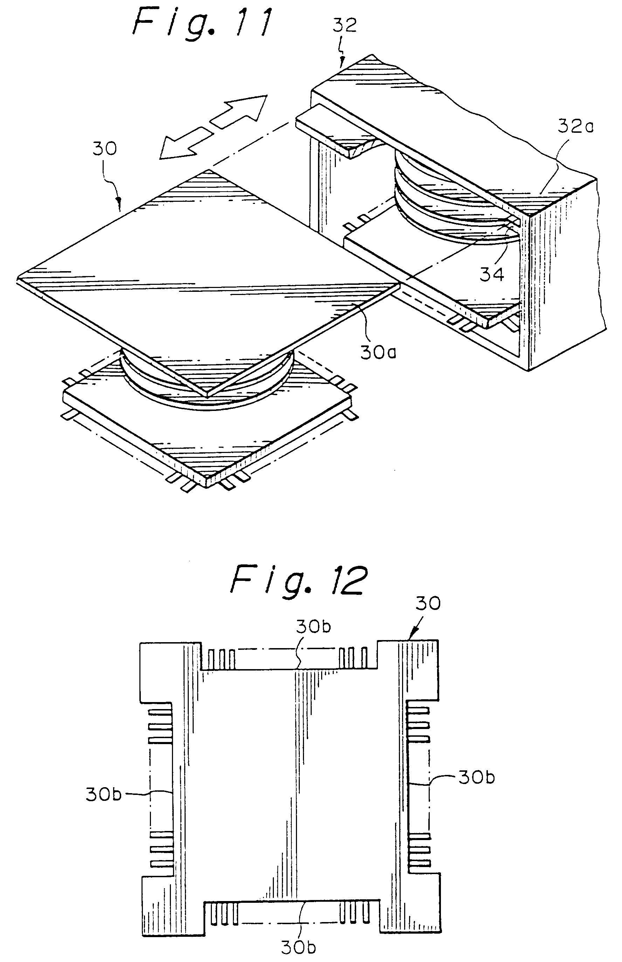

Referring to Fig. 11, a third embodiment of a semiconductor device according to the present invention will be shown. In this embodiment too, the heat radiating fin assembly 30 is constructed in a similar fashion as in the first embodiment explained above, but the topmost heat radiating fin 30a is formed in a block-shape and the dimensions of the contour are made larger than the dimensions of the contour shape of the lead array formed by the large number of leads projecting out from the package body of the semiconductor device. The box-shaped container 32 may also be similarly formed as in the first embodiment, but the distance between the top wall 32a and the guide elements 34 is made a size enabling accommodation of the heat radiating fin 30a. Therefore, if the heat radiating fin 30a is accommodated between the top wall 32a and the guide element 34, the opposing edges of the heat radiating fin 30 in the lateral direction are engaged with the inside surfaces of the two side walls of the box-shaped container 32 and therefore the heat radiating fin 30a cannot rotate or move in position in the box-shaped container 32. That is, once the heat radiating fin 30a is accommodated in the box-shaped container 32, the orientation of the heat radiating fin 30a will not change. Therefore, all of the plurality of semiconductor devices accommodated and held in the box-shaped container 32 can be oriented in the same direction. In summary, the heat radiating fin 30a has the same function as the plate-shaped member 16 of the first embodiment mentioned above.

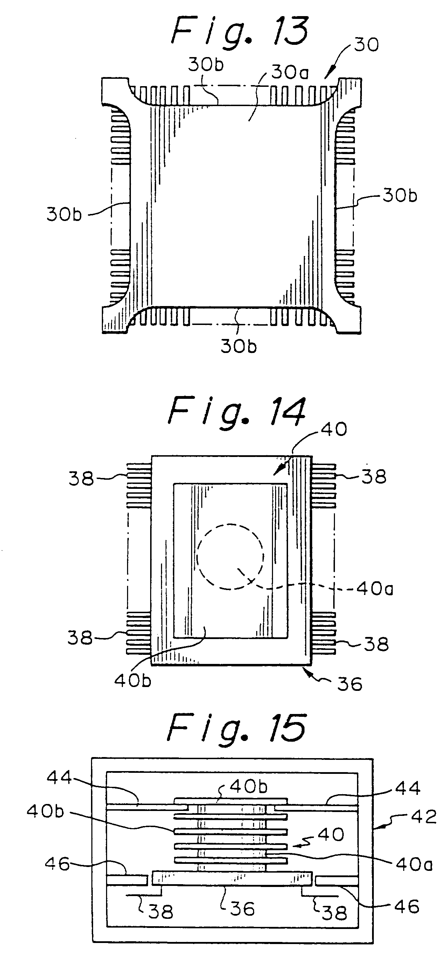

Referring to Fig. 12, a modification of the rectangular heat radiating fin 30a will be shown. In this modification, cutaway portions 30b are formed at each of the sides of the heat radiating fin 30a along the intermediate regions of the same. The contour lines inside the cutaway portions 30b are positioned at the inward regions of the contour shape of the lead array. If this is done, then when the semiconductor device is mounted on the printed circuit board, the majority of the lead connections can be observed through the cutaway portions 30b, so the heat radiating fin of Fig. 12 is advantageous in the case of inspection of lead connection. When a semiconductor device having such heat radiating fins is accommodated and held in the box-shaped container 32, the two adjoining heat radiating fins abut against each other at the corner regions, so there is no contact between groups of leads of two adjoining package bodies projecting out facing each other from the two. Figure 13 shows another modification of the rectangular heat radiating fin 30 of Fig. 12. In this modification, the cutaway portions 30b are made wider than in Fig. 12.

Referring to Fig. 14 and Fig. 15, a fourth embodiment of the semiconductor device according to the present invention is shown. The semiconductor device is of the type generally known as the SOP (small outline package). This type of semiconductor device also is constructed of a rectangular package body 36 in which the IC chip is sealed, a large number of leads 38 projecting out from the opposing sides of the package body 36, and a heat radiating fin assembly 42 mounted at the top surface of the package body 36. In the same way, the package body is formed, for example, from a plastic material or a ceramic material.

In this embodiment too, the heat radiating fin assembly 40 is constructed of a support column 40a extending vertically from the top surface of the package body 36 and a plurality of heat radiating fins 40b extending integrally from the support column 40a in the radial direction and arranged at equal intervals along the axial direction of the support column 40a, but the heat radiating fins 40b are shaped not circularly but as rectangles. Note that the support column 40a and the heat radiating fins 40b are formed from metal materials having excellent heat conductivity in the same way as in the above-mentioned embodiments, for example, from aluminum and copper and that the support column 14a is, for example, soldered to a partially exposed metal surface at the top surface of the package body 10. In this embodiment, the dimensions of the contour shape of the heat-radiating fins 40b are made smaller than the dimensions of the contour shape of the package body 36.

In Fig. 15, the state is shown of the semiconductor device of Fig. 14 accommodated and held in the box-shaped container 42. Guide elements 44 are provided at the inside surfaces of the two side walls of the box-shaped container 42 along the longitudinal axial direction of the same. These guide elements 44 have distances between the projecting tips smaller than the lateral width of the heat-radiating fins 40b and therefore the projecting tips of the guide elements 44 can be inserted between the topmost heat-radiating fin 40b and the heat-radiating fin directly under it. Therefore, the semiconductor devices are hung down from the guide elements 44, so the leads 38 never contact the inside surface of the bottom wall of the box-shaped container 42. However, with such a holding state of the package body 36, the package body 36 can rotate and move in position in the box-shaped container 42, so it is not possible to orient all the semiconductor devices in the box-shaped container in the same direction.

Therefore, in this embodiment, projecting elements are provided at the inside surfaces of the two side walls of the box-shaped container 42 along the longitudinal axial direction of the same. These projecting elements 46 are arranged at the same level as the package body 36 when the semiconductor devices are hung down from the guide elements 44. The projecting tips of the projecting elements 46 may be brought close to the two opposing side surfaces of the package body 36, so the rotation and movement of the package body 36 can be substantially obstructed. That is, once the semiconductor device is accommodated and held in the semiconductor device 42, the orientation of the semiconductor device will not change. Thus, all of the plurality of semiconductor devices accommodated and held in the box-shaped container 42 can be oriented in the same direction.

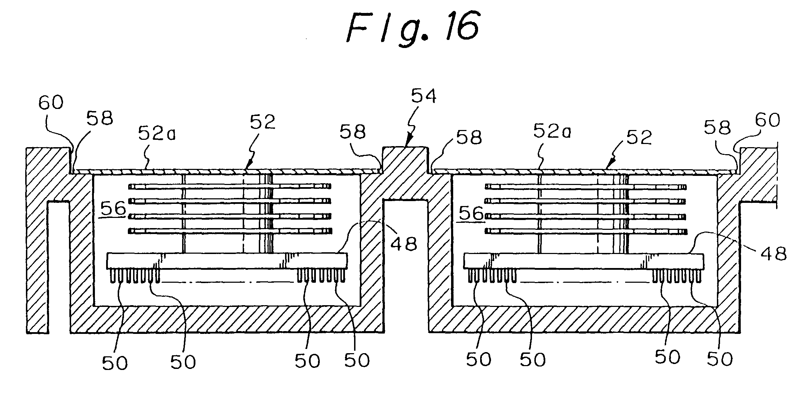

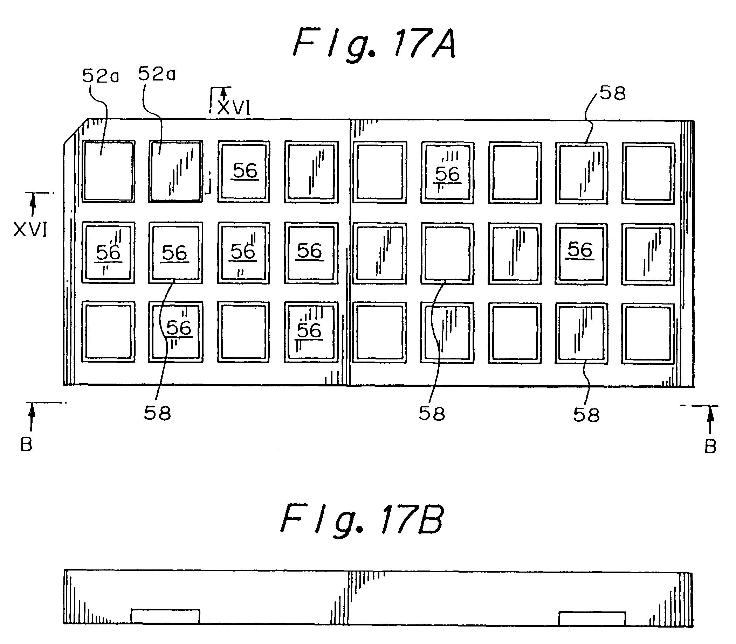

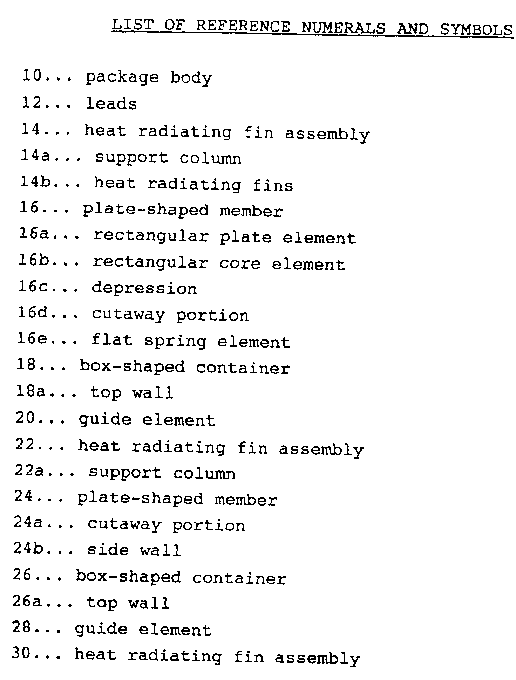

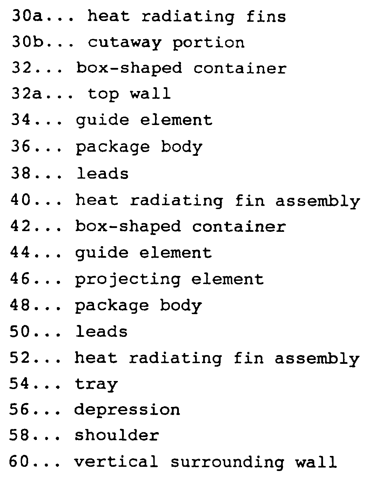

Referring to Fig. 16, Fig. 17A, and Fig. 17B, a fifth embodiment of the semiconductor device according to the present invention will be shown. This semiconductor device is of the type generally known as a PGA (pin grid array package). This type of semiconductor device also is constructed of a rectangular package body 48 in which an IC chip is sealed, a large number of leads 50 projecting out from the bottom of the package body 48, and a heat radiating fin assembly 52 mounted at the top surface of the package body 48. The package body 48 is formed from a plastic material or ceramic material etc. in the same way as the previous embodiments. The heat radiating fin assembly 52 has substantially the same form as the heat radiating fin assembly shown in Fig. 11. That is, the topmost heat radiating fin 52a of the heat radiating fin assembly 52 exhibits a rectangular shape, but the heat radiating fins arranged under it may be made circular. The dimensions of the contour shape of the rectangular heat radiating fin 52a are made larger than the dimensions of the contour shape of the package body 48.

In this embodiment, use may be made of the tray 54 as the container accommodating the semiconductor devices. The tray 54 as a whole is shown in Fig. 17A and Fig. 17B. Such a tray may be formed as an integrally shaped article of, for example, a hard plastic material. As shown in Fig. 16, small chambers, that is, depressions 56, are formed in the tray 54. At the edges surrounding the depressions 56 are formed shoulders 58. When semiconductor devices are accommodated in the depressions 56, the surrounding edges of the rectangular heat radiating fins 52a are placed on the shoulders 58, whereby the semiconductor devices are suspended from the shoulders 58, so the leads 50 will never be brought into contact with the bottom of the depressions 56. Further, as best illustrated in Fig. 16, the rectangular dimensions of the vertical surrounding walls 60 defining the shoulders 58 are made merely slightly larger than the rectangular dimensions of the rectangular heat radiating fin 52a of the heat radiating fin assembly 52, so once a semiconductor device is accommodated and held in a depression 56, the movement of the semiconductor device can be substantially constrained by the vertical surrounding walls 60. Therefore, all of the semiconductor devices accommodated and held in the depressions 56 in the tray 54 may be oriented in the same direction. Note that when transporting the semiconductor devices by the tray 54, the tray 54 is closed by a closing cover (not shown), which cover is fixed in place by a suitable clamping means. In this case, it is preferable that the same number of sponge pieces etc. be attached to the rear side of the cover as the number of depressions 56 so as to prevent any slight movement of the semiconductor devices.

Finally, needless to say, the semiconductor devices of the fifth embodiment mentioned last may be accommodated and held in a box-shaped container as shown in Fig. 11 in accordance with need. As opposed to this, the semiconductor devices of the first, second, and third embodiments may be accommodated and held in the depressions of a tray as shown in Fig. 16. In the semiconductor device of the fifth embodiment, the rectangular heat radiating fin may be made the same in form as the heat radiating fin below it. In this case, the semiconductor device of the fifth embodiment may be accommodated in a box-shaped container as shown in Fig. 15. As opposed to this, in the semiconductor device of Fig. 14, if extending the topmost heat radiating fin of the heat radiating fin assembly 40, the semiconductor devices may be accommodated and held in depressions of the tray shown in Fig. 16.

## Claims

1. A semiconductor device comprising a package body (10; 36), a plurality of leads (12; 38; 50) projecting out of the package body (10; 36; 48), and a heat-radiating fin assembly (14; 22; 30; 40; 52) provided on the top surface of the package body (10; 36), the heat-radiating fin assembly (14; 22) including a support column (14a; 22a; 40a) upstanding from the top surface of the package body and at least one heat-radiating fin (14b; 22b; 30a) extending radially from the support column (14a; 22a; 40a), and being configured to permit and accommodate the holding of the package body (10; 36; 48) in a receiving container (18, 26, 32, 42, 54), characterised by the further provision of a protection and orientation means provided on the heat-radiating fin assembly (14; 22) for protecting the leads (12; 38; 50) and for establishing a predetermined orientation of the package body (10; 36; 48) with respect to rotation about the longitudinal axis of the support column (14a; 22a) when the package body (10; 36) is located in the receiving container (18, 26, 32, 42, 54) in such a way that the package body (10; 36; 48) is prevented from being rotated around the axis of the column.

2. A semiconductor device as set forth in claim 1, wherein the plurality of leads (12) projects laterally outwardly from at least one side of the said package body so as to present a lead array for the semiconductor device,
the protection and orientation means includes a plate-shaped member (16; 24) detachably mounted on the heat-radiating fin (14b) and having an extended portion which projects laterally outwardly beyond the lead array,
the plate-shaped member (16; 24) is adapted to be supported by engagement of this extended portion with the receiving container, and
the protection and orientation means also includes a first orientation surface (14c; 14c₁, 14c₂) on the fin assembly (14), a second orientation surface on the plate-shaped member (16; 24) for engaging the first surface, and a third orientation surface on the plate-shaped member (16; 24) for engaging a corresponding surface of the receiving container (18, 26).

3. A semiconductor device as set forth in claim 2, wherein the first orientation surface (14c; 14c₁, 14c₂) is on the said heat-radiating fin (14b).

4. A semiconductor device as set forth in claim 2, wherein the first orientation surface is on the support column (22a).

5. A semiconductor device as set forth in claim 1, wherein the plurality of leads (12) projects laterally outwardly from at least one side of the package body so as to present a lead array for semiconductor device,
the protection and orientation means includes an extended portion of the heat-radiating fin (30a) which projects laterally outwardly beyond the lead array in order to be supported by engagement with the receiving container,
the protection and orientation means also includes an orientation surface on the extended portion of the heat-radiating fin (30a), this orientation surface engaging a corresponding surface of the receiving container.

6. A semiconductor device as set forth in claim 5, wherein the extended portion of the heat-radiating fin has a cutaway area (30b) which facilitates observation and visual inspection of the lead array.

7. An assembly including a semiconductor device according to any of claims 2 to 6, and a receiving container (18; 26) for accommodating the semiconductor device, wherein the receiving container has an elongated box-shaped configuration presenting a pair of opposed, spaced, vertical, longitudinally extending internal side surfaces and an open end, there being a respective horizontally extending guide element (20; 28) on each side surface, the plate-shaped member (16; 24), or as the case may be the fin (30a), and therefore the package body being supported in the container by engagement of the extended portion of the plate-shaped member or of the fin with the guide elements so that the package body (10) is prevented from rotating about the longitudinal axis of the support column.

8. An assembly including a semiconductor device according to any of claims 2 to 6 and a receiving container for accommodating the semiconductor device, wherein the receiving container comprises a tray (54) having a depression (56) formed therein, and a shoulder (58) disposed beside the depression (56), the package body (10) being suspended in the depression with the plate-shaped member, or as the case may be the fin (30a), supported by engagement of its extended portion with the shoulder so that the package body (10) is prevented from rotating about the longitudinal axis of the support column.

9. An assembly including a semiconductor device according to claim 1, and a receiving container (42) for accommodating the semiconductor device, wherein the plurality of leads (38) projects laterally outwardly from two opposing sides of the package body (36) so as to present a lead array for the semiconductor device,
the receiving container (42) has an elongated box-shaped configuration presenting a pair of opposed, spaced, vertical, longitudinally extending internal side surfaces and an open end, there being a respective horizontally extending guide element (44) and a respective horizontally extending projection element (46) on each side surface,
the protection and orientation means includes an outer peripheral portion of the heat-radiating fin (40b) which engages the guide elements (44), and a respective orientation surface on each side of the package body, the orientation surface engaging a corresponding surface of the projection element (46) for establishing the orientation of the package body (36) within the container with respect to rotation about the longitudinal axis of the support column.

10. An assembly including a semiconductor device according to claim 1 and a receiving container for accommodating the semiconductor device, wherein the plurality of leads (50) projects from the bottom of the package body (48) so as to present a lead array for the semiconductor device, and
the receiving container comprises a tray (54) having a depression (56) formed therein, and a shoulder (58) disposed beside the depression, the package body being suspended in the depression by engagement of an extended portion of the heat-radiating fin with the shoulder so that the package body (48) is prevented from being rotated around the said axis.

## Patentansprüche

1. Halbleitervorrichtung, enthaltend einen Baueinheitenkörper (10; 36), eine Mehrzahl von Leitungen (12; 38; 50), die aus dem Baueinheitenkörper (10; 36; 48) heraustreten und eine wärmeabstrahlende Kühlrippeneinheit (14; 22; 30; 40; 52), die auf der oberen Oberfläche des Baueinheitenkörpers (10; 36) vorgesehen ist, wobei die wärmeabstrahlende Kühlrippeneinheit (14; 22) eine Haltesäule (14a; 22a; 40a), die von der oberen Oberfläche des Baueinheitenkörpers hochsteht, und wenigstens eine wärmeabstrahlende Kühlrippe (14b; 22b; 30a) enthält, die sich radial von der Stützsäule (14a; 22a; 40a) erstreckt, und konfiguriert ist, um das Halten des Baueinheitenkörpers (10; 36; 48) in einem Aufnahmebehälter (18, 26, 32, 42, 54) zu gestatten und einzustellen,
gekennzeichnet durch das weitere Vorsehen von Schutzund Orientierungseinrichtungen, die an der wärmeabstrahlenden Kühlrippeneinheit (14; 22) vorgesehen sind, um die Leitungen (12; 38; 50) zu schützen und bezüglich einer Drehung um die Längsachse der Stützsäule (14a; 22a) eine vorbestimmte Orientierung des Baueinheitenkörpers (10; 36; 48), wenn der Baueinheitenkörper (10; 36) in dem Aufnahmebehälter (18, 26, 32, 42, 54) angeordnet ist, in einer derartigen Weise einzustellen, daß der Baueinheitenkörper (10; 36; 48) daran gehindert ist, um die Achse der Säule gedreht zu werden.

2. Halbleitervorrichtung nach Anspruch 1, bei der eine Mehrzahl von Leitungen (12) von wenigstens einer Seite des Baueinheitenkörpers seitlich nach außen vorsteht, um eine Leitungsanordnung für die Halbleitervorrichtung zu verkörpern,
die Schutz- und Orientierungseinrichtungen ein plattenförmiges Teil (16; 24) enthalten, das an der wärmeabstrahlenden Kühlrippe (14b) lösbar angebracht ist und einen ausgedehnten Teil hat, der seitlich über die Leitungsanordnung nach außen vorsteht,
das plattenförmige Teil (16; 24) ausgelegt ist, daß es durch Eingriff seines ausgedehnten Teils mit dem Aufnahmebehälter abgestützt ist, und
die Schutz- und Orientierungseinrichtungen ferner eine erste Orientierungsfläche (14c; 14c₁, 14c₂) an der Kühlrippeneinheit (14), eine zweite Orientierungsfläche an dem plattenförmigen Teil (16; 24) zum Eingriff mit der ersten Fläche und eine dritte Orientierungsfläche an dem plattenförmigen Teil (16; 24) zum Eingriff mit einer entsprechenden Fläche des Aufnahmebehälters (18, 26) enthält.

3. Halbleitervorrichtung nach Anspruch 2, bei der die erste Orientierungsfläche (14c; 14c₁, 14c₂) an der wärmeabstrahlenden Kühlrippe (14b) ist.

4. Halbleitervorrichtung nach Anspruch 2, bei der die erste Orientierungsfläche an der Stützsäule (22a) ist.

5. Halbleitervorrichtung nach Anspruch 1, bei der eine Mehrzahl von Leitungen (12) von wenigstens einer Seite des Baueinheitenkörpers seitlich nach außen vorsteht, um eine Leitungsanordnung für die Halbleitervorrichtung zu verkörpern,
die Schutz- und Orientierungseinrichtungen einen ausgedehnten Teil der wärmeabstrahlenden Kühlrippe (30a) enthalten, der seitlich über die Leitungsanordnung hinaus vorsteht, um durch Eingriff mit dem Aufnahmebehälter abgestützt zu sein,
die Schutz- und Orientierungseinrichtungen ferner eine Orientierungsfläche an dem ausgedehnten Teil der wärmeabstrahlenden Kühlrippe (30a) enthalten, wobei diese Orientierungsfläche mit einer entsprechenden Fläche des Aufnahmebehälters in Eingriff ist.

6. Halbleitervorrichtung nach Anspruch 5, bei der der ausgedehnte Teil der wärmeabstrahlenden Kühlrippe einen Ausschnittbereich (30b) hat, der die Überwachung und visuelle Inspektion der Leitungsanordnung erleichtert.

7. Einheit, die eine Halbleitervorrichtung nach einem der Ansprüche 2 bis 6 und einen Aufnahmebehälter (18; 26) zum Unterbringen der Halbleitervorrichtung enthält, bei der der Aufnahmebehälter einen länglichen schachtelförmigen Aufbau hat, der ein Paar von entgegengesetzten, beabstandeten, vertikalen, längs verlaufenden Innenseitenoberflächen und ein offenes Ende bietet, wobei es ein entsprechend horizontales verlaufendes Führungselement (20; 28) an jeder Seitenfläche gibt, wobei das plattenförmige Teil (16; 24) oder gegebenenfalls die Kühlrippe (30a) und daher der Baueinheitenkörper in dem Behälter durch Eingriff des ausgedehnten Teils des plattenförmigen Teils oder der Kühlrippe mit den Führungselementen abgestützt werden, so daß der Baueinheitenkörper (10) am Drehen um die Längsachse der Stützsäule gehindert wird.

8. Einheit, die eine Halbleitervorrichtung nach einem der Ansprüche 2 bis 6 und einen Aufnahmebehälter zum Unterbringen der Halbleitervorrichtung enthält, bei der der Aufnahmebehälter ein Tablett (54) enthält, das eine darin ausgebildete Vertiefung (56) und eine neben der Vertiefung (56) angeordnete Schulter (58) hat, wobei der Baueinheitenkörper (10) in die Vertiefung mit dem plattenförmigen Teil oder gegebenenfalls der Kühlrippe (30a) gehängt wird, das bzw. die durch Eingriff seines/ihres ausgedehnten Teils mit der Schulter abgestützt ist, so daß der Baueinheitenkörper 10 am Drehen um die Längsachse der Stützsäule gehindert wird.

9. Einheit, die eine Halbleitervorrichtung nach Anspruch 1 und einen Aufnahmebehälter (42) zum Unterbringen der Halbleitervorrichtung enthält, bei der die Mehrzahl von Leitungen (38) von zwei entgegengesetzten Seiten des Baueinheitenkörpers (36) seitlich nach außen vorstehen, um eine Leitungsanordnung für die Halbleitervorrichtung zu verkörpern,
der Aufnahmebehälter (42) einen länglichen schachtelförmigen Aufbau hat, der ein Paar von entgegengesetzten, beabstandeten, vertikalen, längs verlaufenden Innenseitenoberflächen und ein offenes Ende bietet, wobei es ein jeweiliges horizontal verlaufendes Führungselement (44) und ein jeweiliges horizontal verlaufendes Vorstehelement (46) an jeder Seitenoberfläche gibt,
die Schutz- und Orientierungseinrichtungen ein äußeres Umfangsteil der wärmeabstrahlenden Kühlrippe (40b), das mit den Führungselementen (44) in Eingriff ist, und eine entsprechende Orientierungsoberfläche an jeder Seite des Baueinheitenkörpers enthält, wobei die Orientierungsoberfläche mit einer entsprechenden Fläche des Vorstehelements (46) in Eingriff ist, um die Orientierung des Baueinheitenkörpers (36) innerhalb des Behälters bezüglich einer Drehung um die Längsachse der Stützsäule einstellen.

10. Einheit, die eine Halbleitervorrichtung nach Anspruch 1 und einen Aufnahmebehälter zum Unterbringen der Halbleitervorrichtung enthält, bei der die Mehrzahl von Leitungen (50) vom Boden des Baueinheitenkörpers (48) vorstehen, um eine Leitungsanordnung für die Halbleitervorrichtung zu verkörpern, und
der Aufnahmebehälter ein Tablett (54) mit einer darin ausgebildeten Vertiefung (56) und eine Schulter (58) enthält, die neben der Vertiefung angeordnet ist, wobei der Baueinheitenkörper durch Eingriff eines ausgedehnten Teils der wärmeabstrahlenden Kühlrippe mit der Schulter in die Vertiefung hängt, so daß der Baueinheitenkörper (48) daran gehindert wird, um die Achse gedreht zu werden.

## Revendications

1. Dispositif à semi-conducteur comprenant un ensemble d'emballage (10; 36), une pluralité de conducteurs (12; 38; 50) se projetant hors de l'ensemble d'emballage (10; 36; 48) et un ensemble d'ailettes de rayonnement de chaleur (14; 22; 30; 40; 52) prévu sur la surface supérieure de l'ensemble d'emballage (10; 36), l'ensemble d'ailettes de rayonnement de la chaleur (14; 22) comprenant une colonne de support (14a; 22a; 40a) se dressant de la surface supérieure de l'ensemble d'emballage et au moins une ailette de rayonnement de la chaleur (14b; 22b; 30a) s'étendant radialement de la colonne de support (14a; 22a; 40a) et configurée pour permettre le logement et le maintien de l'ensemble d'emballage (10; 36; 48) dans un récipient de réception (18, 26, 32, 42, 54),
dispositif caractérisé en ce qu'un moyen de protection et d'orientation est prévu, de plus, sur l'ensemble d'ailettes de rayonnement de la chaleur (14; 22) pour protéger les conducteurs (12; 38; 50) et pour établir une orientation prédéterminée de l'ensemble d'emballage (10; 36; 48) par rapport à une rotation selon l'axe longitudinal de la colonne de support (14a; 22a) lorsque l'ensemble d'emballage (10; 36) est situé dans le récipient de réception (18, 26, 32, 42, 54) de telle façon que l'ensemble d'emballage (10; 36; 48) ne puisse tourner selon l'axe de la colonne.

2. Dispositif à semi-conducteur selon la revendication 1, dans lequel la pluralité de conducteurs (12) se projette latéralement vers l'extérieur à partir d'au moins un côté dudit ensemble d'emballage de façon à présenter une rangée de conducteurs pour le dispositif à semi-conducteur;
le moyen de protection et d'orientation comprend une pièce en forme de plaque (16; 24) montée, de façon amovible, sur l'ailette de rayonnement de la chaleur (14b) et possédant une partie étendue se projetant latéralement vers l'extérieur au-delà de la rangée de conducteurs;
la pièce en forme de plaque (16, 24) est prévue pour être supportée par engagement de cette partie étendue avec le récipient de réception; et
le moyen de protection et d'orientation comprend, de même, une première surface d'orientation (14c; 14C1, 14C2) sur l'ensemble d'ailettes (14), une seconde surface d'orientation sur la pièce en forme de plaque (16; 24) pour coopérer avec la première surface et une troisième surface d'orientation sur la pièce en forme de plaque (16; 24) pour coopérer avec une surface correspondante du récipient de réception (18, 26).

3. Dispositif à semi-conducteur selon la revendication 2, dans lequel la première surface d'orientation (14c; 14C1, 14C2) est sur ladite ailette de rayonnement de la chaleur (14b).

4. Dispositif à semi-conducteur selon la revendication 2, dans lequel la première surface d'orientation se trouve sur la colonne de support (22a).

5. Dispositif à semi-conducteur selon la revendication 1, dans lequel la pluralité de conducteurs (12) se projette latéralement vers l'extérieur à partir d'au moins un côté de l'ensemble d'emballage de façon à présenter une rangée de conducteurs pour le dispositif de semi-conducteur;
le moyen de protection et d'orientation comprend une partie étendue de l'ailette de rayonnement de la chaleur (30a) et se projetant latéralement vers l'extérieur au-delà de la rangée de conducteurs de façon à être supportée par coopération avec le récipient de réception; et
le moyen de protection et d'orientation comprend, de même, une surface d'orientation sur la partie étendue de l'ailette de rayonnement de la chaleur (30a), cette surface d'orientation coopérant avec une surface correspondante du récipient de réception.

6. Dispositif à semi-conducteur selon la revendication 5, dans lequel la partie étendue de l'ailette de rayonnement de la chaleur possède une zone de découpe (30b) facilitant l'observation et l'inspection visuelle de la rangée de conducteurs.

7. Ensemble comprenant un Dispositif à semi-conducteur selon l'une quelconque des revendications 2 à 6, et un récipient de réception (18, 26) pour loger le dispositif à semi-conducteur, ensemble dans lequel le récipient de réception présente une forme de boîte allongée munie d'une paire de surfaces latérales internes opposées, espacées, verticales et s'étendant longitudinalement, et une extrémité ouverte, comprenant un élément de guidage respectif (20; 28) s'étendant à l'horizontale sur chaque surface latérale, la pièce en forme de plaque (16; 24) ou, si c'est le cas, l'ailette (30a), et l'ensemble d'emballage étant, par conséquent, supporté dans le récipient par engagement de la partie étendue de la pièce en forme de plaque ou de l'ailette avec les éléments de guidage de telle façon que l'ensemble d'emballage (10) ne puisse pas tourner selon l'axe longitudinal de la colonne de support.

8. Ensemble comprenant un dispositif à semi-conducteur selon l'une quelconque des revendications 2 à 6 et un récipient de réception pour loger le semi-conducteur, dans lequel le récipient de réception comprend un plateau (54) muni d'un creux (56) et un épaulement (58) placé à côté du creux (56), l'ensemble d'emballage (10) étant suspendu dans le creux, la pièce en forme de plaque ou, si c'est le cas, l'ailette (30a) étant supportée par engagement de sa partie étendue avec l'épaulement de telle façon que l'ensemble d'emballage (10) ne puisse tourner selon l'axe longitudinal de la colonne de support.

9. Ensemble comprenant un dispositif à semi-conducteur selon la revendication 1, et un récipient de réception (42) pour loger le dispositif à semi-conducteur, dans lequel la pluralité de conducteurs (38) se projette latéralement vers l'extérieur à partir de deux côtés opposés de l'ensemble d'emballage (36) de façon à présenter une rangée de conducteurs pour le dispositif à semi-conducteur;
le récipient de réception (42) possède une forme de boîte allongée présentant une paire de surfaces latérales internes opposées, espacées, verticales et s'étendant longitudinalement, et une extrémité ouverte, comprenant un élément respectif de guidage (44) s'étendant à l'horizontale et un élément respectif en projection (46) s'étendant à l'horizontale sur chaque surface latérale; et
le moyen de protection et d'orientation comprend une partie périphérique externe de l'ailette de rayonnement de la chaleur (40b) coopérant avec les éléments de guidage (44) et une surface d'orientation respective sur chaque côté de l'ensemble d'emballage, la surface d'orientation coopérant avec une surface correspondante de l'élément de projection (46) pour établir l'orientation de l'ensemble d'emballage (36) dans le récipient par rapport à une rotation selon l'axe longitudinal de la colonne de support.

10. Ensemble comprenant un dispositif à semi-conducteur selon la revendication 1, et un récipient de réception pour loger le dispositif à semi-conducteur, dans lequel la pluralité de conducteurs (50) se projette du fond de l'ensemble d'emballage (48) de façon à présenter une rangée de conducteurs pour le dispositif à semi-conducteur; et
le récipient de réception comprend un plateau (54) présentant un creux (56) et un épaulement (58) placé à côté du creux, l'ensemble d'emballage étant suspendu dans le creux par coopération d'une partie étendue de l'ailette de rayonnement de la chaleur avec l'épaulement de telle façon que l'ensemble d'emballage (48) ne puisse tourner selon ledit axe.
